Europäisches Patentamt

European Patent Office

Office européen des brevets

(11) Publication number: **0 268 821 B1**

# EUROPEAN PATENT SPECIFICATION

(45) Date of publication of patent specification: **22.12.93** (51) Int. Cl.5: **C23C 18/22**

(21) Application number: **87115344.1**

(22) Date of filing: **20.10.87**

(54) **Method for conditioning of a substrate to be electrolessly plated.**

(30) Priority: **27.10.86 US 923291**

(43) Date of publication of application:
**01.06.88 Bulletin 88/22**

(45) Publication of the grant of the patent:
**22.12.93 Bulletin 93/51**

(84) Designated Contracting States:
**DE FR GB IT**

(56) References cited:
**US-A- 4 568 562**

**PATENT ABSTRACTS OF JAPAN, vol. 10, no. 63 (C-332)[2120], 13th March 1986; & JP-A-60 200 967**

(73) Proprietor: **International Business Machines Corporation**
**Old Orchard Road**
**Armonk, N.Y. 10504(US)**

(72) Inventor: **Babu, Suryadevara V.**
**Peyton Hall Clarkson Univ.**
**Potsdam, N.Y. 13676(US)**
Inventor: **Jones, Gerald Walter**
**1112 Reynolds Rd.**
**Johnson City, N.Y. 13790(US)**
Inventor: **Lu, Neng-Hsing, Dr.**
**72 Greenbriar Drive**
**Berkley Heights, N.J. 07922(US)**

(74) Representative: **Mönig, Anton, Dipl.-Ing.**
**IBM Deutschland Informationssysteme GmbH,**
**Patentwesen und Urheberrecht**
**D-70548 Stuttgart (DE)**

EP 0 268 821 B1

**Description**

The present invention is concerned with conditioning a dielectric material and is particularly concerned with treating a dielectric substrate to prepare the substrate for the electroless deposition of a conductive metal thereon. The conditioning can be in the holes and/or on the surfaces of the substrate. The present invention finds particular applicability in the manufacture of printed circuit cards and boards.

In the manufacture of printed circuit cards and boards, a dielectric sheet material is employed as the substrate. A conductive circuit pattern is provided on one or both of the major surfaces of the substrate.

A conductive pattern can be formed on the surface of a substrate using a variety of known techniques. These known techniques include the subtractive technique where a layer of copper is etched to form the desired circuit pattern, the EDB (electroless direct bond) technique where copper is electrolessly plated directly on the surface of the substrate in the desired pattern, the peel-apart technique where the desired circuit pattern is plated up from a thin layer of peel-apart copper. In addition, connections between layers are made by means of plated through holes or vias. In plating such holes, copper must be plated directly on the dielectric substrate (on the walls of the holes or vias). In addition, if one employs the electroless direct bond technique, it is necessary to plate directly on the surface of the substrate.

Since the dielectric substrate is nonconductive, in order to plate on the substrate (either on the walls of the holes or on the surface of a substrate) the substrate must be seeded or catalyzed prior to the deposition of metal onto the substrate.

JP-A-60 200 967 discloses a method for plating organic polymer sheet with metal, this method comprising uniformly recessing the surface of the sheet by irradiating plasma thereon before electroless plating.

Among the more widely employed procedures for catalyzing a substrate is the use of a stannous chloride sensitizing solution and a palladium chloride activator to form a layer of metallic palladium particles. For instance, one method for catalyzing a dielectric substrate is exemplified by U.S. Patent No. 3,011,920 which includes sensitizing the substrate by first treating it with a solution of a colloidal metal, accelerating the treatment with a selective solvent to remove protective colloids from the sensitized dielectric substrate and then electrolessly depositing a metal coating on the sensitized substrate; for example, with copper from a solution of a copper salt in a reducing agent. Also, as suggested, in U.S. Patent No. 3,009,608, a dielectric substrate can be pretreated by depositing a thin film of a "conductivator" type of metal particles such as palladium metal from a semicolloidal solution onto the dielectric substrate to provide a conducting base that permits electroplating with conductive metal on the conductivated base.

U.S. Patent No. 4,066,809 discloses the use of a so-called "triple seeding" technique. This technique disclosed in U.S. Patent No. 4,066,809 includes contacting the surfaces of the dielectric material with an aqueous stannous chloride sensitizing solution followed by contacting the surfaces of the dielectric material with an aqueous palladium chloride activator solution and then followed by contacting the surfaces of the dielectric material with an aqueous palladium chloride/stannous chloride/hydrochloric acid seeder bath.

More recently, it has been disclosed in U.S. Patents 4,478,883 and 4,554,182, disclosures of which are incorporated herein by reference, that increased efficiency of the seeding or activation of a dielectric substrate for subsequent electroless plating which in turn results in improved and more reliable electroless plating of conductive metals can be obtained by conditioning the surface with a composition containing a multifunctional ionic polymer material containing at least two available ionic moieties. Included among such materials are copolymers of a nonreactive backbone chain of polyacrylamide to which is attached a short chain of a tetra-alkyl-ammonium compound.

Although the conditioning processes disclosed in U.S. Patents 4,554,182 and 4,478,883 are satisfactory for the most part, they require wet processing and suffer from those problems inherently associated with wet process techniques. Included among the difficulties associated with wet processing techniques are environmental and safety concerns. For example, the aqueous compositions are susceptible to hydrolysis and bacterial attack. This requires the disposal of such compositions on a fairly regular basis such as daily and the preparation of new compositions on a regular basis.

Also, extreme care must be exercised in controlling the composition and the amount of the polymer retained on a substrate surface for consistency from batch to batch. This in turn entails careful control of the agitation of the composition, the temperature, and time that the coated substrate is present in a subsequent rinse bath and the purity of the compositions employed. In view of the necessary control, at times, the amount of polymer retained on a substrate varies from that desired which in turn results in differing amounts of seeder composition retained on the surface. This, in turn, can cause problems if the deviation from the amount desired is too great. For instance, the concentration of seeder retained on a substrate is critical since if too little is present poor plating occurs and if too much is present blistering of the resist and

2

subsequent plated copper occurs.

It has also been noted that some degradation in the adhesion of the photoresist employed to delineate the subsequently plated metal can occur when employing the above wet processing techniques.

It is an object of the present invention to provide a process for conditioning the dielectric substrate that does not require wet chemical processing and accordingly eliminates those problems inherent in wet chemical processing.

It is another object of the present invention to provide a process for improving adhesion between the substrate and photoresist that is employed in delineating the pattern of subsequently plated metal.

These objects are achieved by a method as disclosed in claim 1.

The present invention makes it possible to achieve excellent plating, both in the holes and if an EDB process is being used on the major surfaces with the use of only a single seeder step.

Advantageous embodiments of the inventive method are disclosed in the subclaims.

The invention will become more apparent from the following detailed description dealing with the best and various modes for carrying out the invention.

The process of the present invention is applicable to treating or conditioning a wide variety of dielectric (nonconductor) substrates. Dielectric substrates and preferably thermosetting resins may be treated in accordance with the present invention.

Typical thermosetting polymeric materials include epoxy, phenolic base materials, polyimides and polyamides. The dielectric materials may be molded articles of the polymers containing fillers and/or reinforcing agents such as glass filled epoxy or phenolic base materials. Examples of some phenolic type materials include copolymers of phenol, resorcinol and cresol. The most preferred substrates treated in accordance with the present invention contain polar groups that are reactive with ammonia and/or amines and include hydroxy and epoxy moieties.

Typical epoxy resins include the bisphenol A type resins obtained from bisphenol A and epichlorohydrin, resinous materials obtained by the epoxidation of novolak resins produced from a phenolic material such as phenol and an aldehyde such as formaldehyde with epichlorohydrin, polyfunctional epoxy resins such as tetraglycidyldiaminodiphenyl methane, and alicyclic epoxy resins such as bis(3,4-epoxy-6-methylcyclohexamethyl) adipate. The most usual epoxy employed is of the bisphenol A type.

Also, the resinous epoxy compositions can contain accelerating agents and curing agents, as well-known in the art. Examples of suitable curing agents include polyamines, primary, secondary, and tertiary amines, polyamides, polysulfones, urea-phenol-formaldehyde, and acids or anhydrides thereof. In addition, suitable curing agents include Lewis acid catalysts such as $BF_3$ and complexes thereof.

The dielectric substrate usually contains fillers and/or reinforcing fibers such as glass fibers. Such compositions containing fibers are usually prepared by impregnating the fibers with the epoxy composition. The amount of the epoxy composition when combined with the fibers is usually about 30% to about 70% by weight and more usually about 55% to about 65% by weight of the total of the solids content of the epoxy composition and the fiberglass.

After combining with the reinforcing fibers, the composition is cured to the B-stage and molded to the desired shape, such as a sheet. When sheets are employed, the thickness is usually about 38.1 $\mu$m (1.5 mils) to about 203 $\mu$m (8 mils) and preferably about 50 $\mu$m (2 mils) to about 76.2 $\mu$m (3 mils). The curing to the B-stage is generally achieved by using temperatures of about 80°C to about 110°C and for times of about 3 minutes to about 10 minutes.

The substrate can then be laminated onto another supporting substrate as is generally practiced. For instance, the bonding of substrates can be carried out by pressing together a number of sheets of the substrate in a preheated laminating press at a predetermined pressure and temperatures as, for example, about 13.8 bar (200 psi) to about 34.5 bar (500 psi) and preferably about 17.2 bar (250 psi) to about 20.7 bar (300 psi) and at about 180°C. The time of the pressing operation is variable, depending upon the particular materials employed and the pressures applied. About 1 hour is adequate for the above conditions.

The term "surface" as employed herein, refer to the surfaces inside through holes as well as the major surfaces of the substrate. For instance, the present invention is useful for seeding the plated through holes where the circuitry is being applied by either additively plating upon a thin layer of peel-a-part copper or by a subtractive process. Also, the present invention is useful for seeding in a solution where an electroless direct bond (EDB) is being used. In this case, the circuitry is additively plated both in the holes and over the surface of the substrate in those areas where desired.

Prior to the initiation of the process of the present invention for treating the dielectric substrate, the required through holes in the substrate are made and the dielectric with through holes is suitably cleaned and preconditioned.

For instance, the preconditioning can include creation of active sites by physical means such as the sacrificial foil technique, sand, and/or vapor blasting and/or chemical methods such as solvent swelling. A typical solvent is N-methyl pyrrolidone. The substrate can also be pretreated with a sulfochromic acid composition.

In accordance with the present invention, the substrate is exposed to a gaseous plasma obtained from ammonia and/or an organic amine. Suitable organic amines are represented by the formulas: $R^1N(R^2)_2$ and $(R^2)_2NR^3N(R^2)_2$.

$R^1$ is a monovalent hydrocarbon group.

Each $R^2$ individually is a hydrogen atom or a monovalent hydrocarbon group. $R^3$ is a divalent hydrocarbon group. The hydrocarbon groups usually contain 1 to about 12 carbon atoms, and preferably 1 to 4 carton atoms.

Moreover, the hydrocarbon groups bonded to the nitrogen atoms can be substituted with substituent atoms such as halogen atoms, hydroxy groups, and alkoxy groups.

Examples of suitable amines include methylamine, dimethylamine, trimethylamine, diethylamine, triethylamine, n-propylamine, di-n-propylamine, tri-n-propylamine, n-butylamine, n-amylamine, n-hexylamine, laurylamine, ethylenediamine, trimethylenediamine, hexamethylenediamine, ethanolamine, diethanolamine, allylamine, allyldimethylamine, 2-aminodiethylether, 1-dimethylamino-2-chloroethane, cyclopropylamine, cyclohexylamine, ethyleneimine, and 1-methylethyleneimine.

The ammonia and/or amine can be used alone or combinations of such can be employed. In addition, if desired, the ammonia and/or amines can be diluted with an inorganic gas such as helium, argon, neon, nitrogen, nitrous oxide, nitric oxide, nitrogen dioxide, oxygen, air, carbon monoxide, carbon dioxide, and hydrogen. In the event inorganic diluent gases are employed in the plasma atmosphere it is preferred that such be employed in amounts of one-tenth or below of the partial pressure of the ammonia and/or organic amine gas.

The plasma treatment comprises first evacuating the plasma reaction chamber to a desired base pressure such as below about $1.33 \times 10^{-4}$ mbar ($10^{-5}$ torr). After the chamber has had an opportunity to stabilize at a desired working pressure, by flowing the ammonia and/or organic amine containing gas, at rates of about 20 to about 4000 standard cubic centimeters per minute typical of which is about 1.000 standard cubic centimeters per minute, a current at a desired frequency and desired level of power is supplied by means of electrodes and an external power source. The desired pressure of the plasma treatment is about 0.13 mbar (0.1 torr) to about 5.33 mbar (4 torr), and preferably about 0.27 mbar (0.2 torr) to about 1.07 mbar (.8 torr). The temperature of the substrate is generally about normal room temperature to about 149°C (300°F). The power density employed is usually about 0.01 watts per square centimeter to about 0.5 watts per square centimeter of the area of one surface of the electrodes of the plasma apparatus.

The treatment is normally carried cut for about 10 minutes to about 150 minutes.

The power and current that are supplied to the electrodes of the plasma apparatus cause a plasma to be created in the reaction chamber thereof wherein is placed the substrates to be treated.

The power which is employed may be obtained from any source of electrical energy, a specific example being a generator.

Plasma reactors suitable for carrying out the plasma treatment of the present invention are commercially available and need not be discussed herein in any detail. Typical commercially available plasma reactors suitable for carrying out the present invention are Phoenix Material Company (PMC) Model 711; Branson IPC-Parallel Plate Reactor Model 7415; in-line plasma system available from Koksai, Applied Plasma System's plasma reactor; and Technics' plasma reactor.

After the substrate is treated with the plasma in accordance with the present invention, the substrate is activated by contact with a composition containing a catalytic composition capable of initiating the electroless plating process. The composition contains a metal which can directly provide the catalytic sites or serves as a precursor which leads to the catalytic sites. The metal present in the catalytic composition may be in the elemental form, an alloy, or compound, or mixtures thereof. The preferred metal catalysts are precious metals such as gold, palladium, and platinum.

The most preferred catalyst is palladium. A typical palladium composition contains about 1.2 to 2.5 grams/liter of a palladium salt which is preferably $PdCl_2$, about 80 to 150 grams/liter of a stannous salt which is preferably $SnCl_2 \cdot 2H_2O$, and about 100 to 150 milliliters per liter of an acid which is preferably HCl. When HCl is provided in the form of a 37% HCl solution, about 280 to about 360 milliliters of the HCl is preferably employed. The most preferred compositions contain about 1.5 grams per liter of $PdCl_2$, about 80 grams per liter of $SnCl_2 \cdot 2H_2O$ and about 280 milliliters per liter of 37% HCl. The composition is usually maintained at a temperature of about 18° ± 5°C (65° ± 10°F).

4

A typical triple seeder process includes first contacting the dielectric substrate surfaces and/or the through holes with a stannous chloride sensitizing solution ($SnCl_2$/HCl). Typically, the contacting time is from 4 to 10 minutes and more typically about 7 minutes. The stannous chloride is then rinsed from the substrate and/or through holes with water. A hot water rinse being in a temperature range from 55°C to about 80°C is typical.

The next seeding step includes contacting the dielectric substrate surfaces and/or the through hole surfaces with a palladium chloride activator. This may be accomplished by immersing the dielectric in the palladium activator bath for 2 ± 1 minutes.

The third step of the seeding process includes contacting the substrate surface and/or through hole surfaces with a palladium chloride/stannous chloride/hydrochloric acid seeder bath. The contact time can vary from 1 to 10 minutes with about 5 minutes being typical.

In preparing the solution for the first step of the process, a combination of stannous chloride having a content of between 53 and 57 grams per liter of $SnCl_2 \bullet 2H_2O$ with 37% hydrochloric acid at a ratio of 50 milliliters per liter with the pH of the solution adjusted to a range between 0.2 and 0.5 provides a desired preconditioning solution. The $SnCl_2.2H_2O$ is dissolved in the HCl with the resulting mixture being added to a tank of deionized water. The pH is typically about 0.4 and the solution is maintained at a temperature of 18°± 5°C (65°± 10°F).

For the second step of the triple seeder process, the palladium chloride bath is formed by mixing 50 grams of palladium (with a concentration of 0.13 to 0.17 grams per liter) with approximately 3780 milliliters of 37% hydrochloric acid. The $PdCl_2$ is dissolved in the hydrochloric acid with the resultant mixture being added to a tank of deionized water. Again, the bath is maintained at a temperature of 18°± 5°C (65°± 10°F), and the pH is maintained between 0.75 and 1.00.

The final catalytic palladium chloride/stannous chloride/hydrochloric acid seeder bath includes a bath comprising 1.2 to 2.5 grams per liter of $PdCl_2$ with 80 to 150 grams per liter of $SnCl_2 \bullet 2H_2O$ together with between 280 and 360 milliliters of 37% HCl per liter of solution. This third seeding bath is again maintained at a temperature of 18°± 5°C (65°± 10°F). A typical solution of the bath includes about 1.5 grams per liter of $PdCl_2$, 100 grams per liter of $SnCl_2$ and 280 milliliters per liter of 37% hydrochloric acid.

Next a metal such as nickel or copper, is plated by electroless plating onto the treated surface. The metal is coated to the desired thickness. The preferred metal employed is copper. Typical copper electroless plating baths and their method of application are disclosed in U.S. Patents 3,844,799, 4,152,467, disclosures of which are incorporated herein by reference.

The copper electroless plating bath is generally an aqueous composition which includes a source of cupric ion, a reducing agent, a complexing agent for the cupric ion, and a pH adjuster. The plating baths also preferably include a cyanide ion source and a surface active agent.

The cupric ion source generally used is a cupric sulfate or a cupric salt of the complexing agent to be employed. When employing cupric sulfate, it is typical to use amounts from about 3 to about 15 grams/liter and most typically from about 8 to about 12 grams/liter. The most common reducing agent employed is formaldehyde which is generally used in amounts from about 0.7 to about 7 grams per liter and most preferably from about 0.7 to about 2.2 grams per liter. Examples of some other reducing agents include formaldehyde precursors or derivatives such as paraformaldehyde, trioxane, dimethyl hydantoin, glyoxal; borohydrides such as alkali metal borohydrides (sodium and potassium borohydride) and substituted borohydrides such as sodium trimethoxyborohydride; boranes such as amineborane (isopropyl amine borane and morpholine borane). Hypophosphite reducing agents can also be used for electroless Ni and Cu plating.

Examples of some suitable complexing agents include Rochelle salts, ethylene diamine tetraacetic acid, the sodium (mono-, di-, tri-, and tetra-sodium) salts of ethylene diamine tetraacetic acid, nitrilotetraacetic acid and its alkali salts, gluconic acid, gluconates, triethanol amine, glucono-(gamma)-lactone, modified ethylene diamine acetates such as N-hydroxyethyl ethylene diamine triacetate. In addition, a number of other suitable cupric complexing agents are suggested in U.S. Patents 2,996,408; 3,075,856; 3,075,855; and 2,938,805. The amount of complexing agent is dependent upon the amount of cupric ions present in the solution and is generally from about 20 to about 50 grams/liter, or in a 3-4 fold molar excess.

The plating bath can also contain a surfactant that assists in wetting the surface to be coated. A satisfactory surfactant is, for instance, an organic phosphate ester available under the trade designation Gafac RE-610. Generally, the surfactant is present in amounts from about 0.02 to about 0.3 grams/liter. In addition, the pH of the bath is also generally controlled, for instance, by the addition of a basic compound such as sodium hydroxide or potassium hydroxide in the desired amount to achieve the desired pH. The preferred pH of the electroless plating bath is between 11.6 and 11.8.

Also the plating bath can contain a cyanide ion, about 10 to about 25 milligrams per liter to provide a cyanide ion concentration in the bath within the range of 0.0002 to 0.0004 molar. Examples of some cyanides which can be employed according to the present invention are the alkali metal, alkaline earth metal, and ammonium cyanides. In addition, the plating baths can include other minor additives as is well known in the prior art.

The plating baths generally employed have a specific gravity within the range of 1.060 to 1.080. In addition, the temperature of the bath is usually maintained between 70° and 80°C. and most usually between 70° and 75°.

In addition, if desired, the plating with the copper can be carried out employing dual plating bath techniques such as those along the lines suggested in U.S. Patents 4,448,804 and 4,525,390, disclosures of which are incorporated herein by reference.

The following nonlimiting examples are presented to further illustrate the present invention.

## EXAMPLE 1

An epoxy-glass fiber prepreg is placed in a reaction chamber of a plasma generating apparatus available under the trade designation Phoenix Material Company (PMC) model 711 unit. Ammonia is conveyed at a rate of about 15.48 l/s (1000 standard cubic centimeters per minute) to the top circular metallic electrode of the apparatus. The pressure employed is about 0.60 mbar (450 millitorr), the power about 380 watts, and the power density is about 0.5 watts per centimeter square of the area of the lower electrode. The treatment is carried out for about 30 minutes.

The substrate is then immersed in a bath of about 1.5 grams per liter of $PdCl_2$, about 100 grams per liter of $SnCl_2$, and about 280 milliliters per liter of 37% HCl at about 18°C (65°F) for about three minutes. The substrate is then accelerated with an 8% hydrochloric acid solution.

The substrates are then analyzed for seeder retention by the direct current plasma procedure. In particular, a known surface area of the seeded substrate is digested in aqua regia to remove the tin and palladium compounds. The sample is diluted to a known volume and aspirated into an argon plasma at about 3,000°K - 5,000°K between tungsten electrodes. The hot plasma causes the elements to emit at characteristic wavelengths. The emission is compared to standard samples from which the concentration in the solution and thus the amount on a given volume of substrate can be calculated. The reported values are micrograms $(\mu g)/cm^2$. The procedure is run twice. The average palladium found is 2.61 ppm and the average tin found is 2.27 ppm.

A photoresist is applied to the seeded substrate and the photoresist is imaged and developed. The substrate containing the developed photoresist is then immersed in a copper electroless additive plating bath and plated to a thickness of about 50.8 $\mu$m (2 mils). The electroless plating bath contains about 10 grams per liter of $CuSO_4 \cdot 5H_2O$, 35 grams per liter of ethylene diamine tetraacetic acid dihydrate, 0.25 grams per liter of Gafac RE-610, about 14 milligrams per liter of sodium cyanide and about two milliliters per gram of 37% aqueous formaldehyde. The specific gravity of the plating bath is about 1.07, the pH is 11.7 by the addition of NaOH and the temperature of the bath is about 73°C ± 5°C. The oxygen content of the bath is maintained at about 2.5 to about 3.5 ppm. The gas flow rate is about 5.66 l/s (12 SCFM).

The substrates are then tested for peel strength by the procedure discussed by Lee, et al., Micromechanics of Multilayer Printed Circuit Boards, IBM, Journal of Research and Development, Vol. 28, No. 6, November 1984, Paper 715, under the heading "PTH peel test", disclosure of which is incorporated herein by reference. The peel strength is about 1455 g/cm (8.15 pounds per inch).

## COMPARISON EXAMPLE 2

The above procedure is repeated, except that the epoxy prepreg is not pretreated in accordance with the plasma treatment of the present invention. The results obtained are about 0.84$\mu$g/cm$^2$ of palladium and about 0.74$\mu$g/cm$^2$ of tin. In addition, the peel strength is only about 957 g/cm (5.36 pounds per inch).

## EXAMPLES 3-10

Example 1 is repeated, except that the plasma treatment employs the parameters recited in the table below. Also included in table 1 below are the results from Example 1 and comparison Examples 2 and 3 to facilitate comparing the effect of the present invention with the prior art.

A comparison of the treatment of the present invention with no treatment clearly illustrates the improved results obtained by the present invention.

TABLE

| | Example No. | Power (Watts) | % Amine | Pressure (mT) | Sn ($\mu g/cm^2$) | Pd ($\mu g/cm^2$) | Peeling Strength g/cm (lbs/in.) |
|---|---|---|---|---|---|---|---|
| No Treat- ment | 2 | | | | 0.74 | 0.84 | 957.20 (5.36) |
| $NH_3$ Plasma | 1 | 380 | 0 | 450 | 2.64 | 3.03 | 1455.43 (8.15) |
| $NH_3$ Plasma | 3 | 350 | 0 | 500 | 2.33 | 2.68 | 1307.20 (7.32) |
| $NH_3$ Plasma | 4 | 380 | 0 | 500 | 2.43 | 2.82 | 1230.42 (6.89) |
| $NH_3$ Plasma | 5 | 410 | 0 | 450 | 2.06 | 2.33 | 1292.92 (7.24) |
| $NH_3$ + Ethy- lene dia- mine | 6 | 380 | 0 | 550 | 2.53 | 2.82 | 1412.57 (7.91) |
| | 7 | 410 | 0 | 550 | 2.47 | 2.77 | 1271.49 (7.12) |
| $NH_3$ + Ethy- lene dia- mine | 8 | 380 | 15 | 500 | 3.11 | 3.60 | 1182.20 (6.62) |
| | 9 | 380 | 30 | 500 | 2.51 | 3.03 | 1334.00 (7.47) |
| | 10 | 380 | 60 | 500 | 2.75 | 3.32 | 1201.84 (6.73) |

## Claims

1. A method for conditioning at least one surface of a dielectric substrate material, containing polar groups that are reactive with ammonia or amines, for the electroless plating of a conductive metal thereon which comprises exposing said substrate to a gaseous plasma from a gas selected from the group of ammonia, organic amines, or mixtures thereof; wherein the pressure of the plasma is about 0.133 mbar (0.1 torr) to about 5.32 mbar (4 torr) and preferably about 0.266 mbar (0.2 torr) to about 1.06 mbar (0.8 torr), the employed power density is about 0.01 to about 0.5 W/cm² and the treatment time from about 10 to about 150 minutes; and then activating the substrate by contacting it with a composition containing a colloidal catalyst to provide directly, or as a precursor leading to catalytic sites capable of electroless plating, initiation of a conductive metal thereon.

2. Method according to claim 1 wherein said plasma is from a mixture of ammonia and ethylene diamine.

3. Method according to any one of claims 1 to 2 wherein said dielectric substrate consists of an epoxy prepreg.

4. Method according to any one of claims 1 to 3 wherein the the surface is activated with a composition containing a palladium chloride.

5. Method according to any one of claims 1 to 4 wherein said palladium chloride composition contains about 1.2 to about 2.5 grams per liter of palladium chloride, about 80 to about 150 grams per liter of $SnCl_2 \cdot 2H_2O$, and about 280 to about 360 milliliters per liter of 37% HCl.

6. Method according to claim 5 wherein the activating is with a composition containing about 1.5 grams per liter of $PdCl_2$, about 80 grams per liter of $SnCl_2 \cdot 2H_2O$, and about 280 milliliters per liter of 37% aqueous HCl.

7. Method according to claim 1 to 6 which additionally includes contacting the activated surface with an electroless plating bath containing conductive metallic ions therein.

8. Method according to claim 7 wherein said conductive ions include nickel or copper.

9. Method according to any one of claim 1 to 8 wherein said at least one surface includes through-holes in a substrate.

**Patentansprüche**

1. Verfahren zur Vorbehandlung von wenigstens einer Oberfläche eines dielektrischen Substratmaterials, das polare Gruppen enthält, die mit Ammoniak oder Aminen reagieren können, um darauf durch stromlose Metallisierung ein leitfähiges Metall zu plattieren, wobei das Verfahren das Aussetzen des Substrats gegenüber einem gasförmigem Plasma aus einem Gas, das aus der Gruppe Ammoniak, organische Amine oder deren Gemische ausgewählt wird, umfaßt; wobei der Plasmadruck etwa 0,133 mbar (0,1 Torr) bis etwa 5,32 mbar (4 Torr) und vorzugsweise etwa 0,266 mbar (0,2 Torr) bis etwa 1,06 mbar (0,8 Torr) beträgt, die eingesetzte Leistungsdichte etwa 0,01 bis etwa 0,5 $W/cm^2$ beträgt und die Behandlungsdauer etwa 10 bis etwa 150 Minuten beträgt; sowie die Aktivierung des Substrats durch Zusammenbringen mit einer Mischung, die einen kolloidalen Katalysator enthält, der direkt katalytische Plätze liefert oder als Vorstufe zu letzteren führt, die dazu in der Lage sind, die stromlose Metallisierung des Substrats mit einem leitfähigen Metall zu initialisieren.

2. Verfahren gemäß Anspruch 2, wobei das Plasma aus einem Gemisch aus Ammoniak und Ethylendiamin erzeugt wird.

3. Verfahren gemäß einem der Ansprüche 1 bis 2, wobei das dielektrische Substrat aus einem Epoxidharz-Prepreg besteht.

4. Verfahren gemäß einem der Ansprüche 1 bis 3, wobei die Oberfläche mit einer ein Palladiumchlorid enthaltenden Mischung aktiviert wird.

5. Verfahren gemäß einem der Ansprüche 1 bis 4, wobei die Palladiumchlorid enthaltende Mischung etwa 1,2 bis etwa 2,5 Gramm Palladiumchlorid pro Liter, etwa 80 bis etwa 150 Gramm $SnCl_2 \cdot 2H_2O$ und etwa 280 bis etwa 360 Milliliter 37%ige HCl pro Liter enthält.

6. Verfahren gemäß Anspruch 5, wobei die Aktivierung mit einer Mischung durchgeführt wird, die etwa 1,5 Gramm $PdCl_2$ pro Liter, etwa 80 Gramm $SnCl_2 \cdot 2H_2O$ pro Liter und etwa 280 Milliliter wäßrige 37%ige HCl pro Liter enthält.

7. Verfahren gemäß Anspruch 1 bis 6, das zusätzlich das Zusammenbringen der aktivierten Oberfläche mit einem leitfähige Metallionen enthaltenden Bad für die stromlose Metallisierung beinhaltet.

8. Verfahren gemäß Anspruch 7, wobei die leitfähigen Ionen Nickel oder Kupfer umfassen.

9. Verfahren nach einem der Ansprüche 1 bis 8, wobei wenigstens eine Oberfläche Durchverbindungen in einem Substrat enthält.

EP 0 268 821 B1

**Revendications**

1. Procédé de traitement d'au moins une surface d'un matériau de substrat diélectrique, contenant des groupes polaires qui réagissent à l'ammoniac ou aux amines, pour la métallisation chimique d'un métal conducteur dessus, comprenant l'exposition dudit substrat à un plasma gazeux à partir d'un gaz sélectionné dans le groupe des ammoniac, amines organiques, ou des mélanges de ceux-ci, dans lequel la pression du plasma est d'environ 0,133 mbar (0,1 torr) à environ 5,32 mbar (4 torr) et, de préférence, d'environ 0,266 mbar (0,2 torr), à environ 1,06 mbar (0,8 torr), la densité d'énergie employée est d'environ 0,01 à environ 0,5 W/cm$^2$, et le temps de traitement allant d'environ 10 à environ 150 minutes; et ensuite l'activation du substrat en le mettant en contact avec une composition contenant un catalyseur colloïdal pour assurer directement, ou en tant que précurseur conduisant à des emplacements catalytiques capables de métallisation chimique, l'amorçage d'un métal conducteur dessus.

2. Procédé selon la revendication 1, dans lequel ledit plasma est un mélange d'ammoniac et d'éthylène diamine.

3. Procédé selon l'une quelconque des revendications 1 et 2, dans lequel ledit substrat diélectrique est une préparation époxy.

4. Procédé selon l'une quelconque des revendications 1 à 3, dans lequel la surface est activée par une composition contenant un chlorure de palladium.

5. Procédé selon l'une quelconque des revendications 1 à 4, dans lequel ladite composition de chlorure de palladium contient environ 1,2 à environ 2,5 grammes par litre de chlorure de palladium, environ 80 à environ 150 grammes par litre de $SnCl_2.2H_2O$, et environ 280 à environ 360 millilitres par litre de 37% de HCl.

6. Procédé selon la revendication 5, dans lequel l'activation se fait à l'aide d'une composition contenant environ 1,5 gramme par litre de $PdCl_2$, environ 80 grammes par litre de $SnCl_2.2H_2O$, et environ 280 millilitres par litre de 37% de HCl aqueux.

7. Procédé selon l'une quelconque des revendications 1 à 6, comprenant en outre la mise en contact de la surface activée avec un bain de métallisation chimique contenant dedans des ions métalliques.

8. Procédé selon la revendication 7, dans lequel lesdits ions conducteurs sont du nickel ou du cuivre.

9. Procédé selon l'une quelconque des revendications 1 à 8, dans lequel ladite au moins une surface comporte des trous directs faits dans un substrat.

9